# EUROPÄISCHE PATENTANMELDUNG

(11) **EP 2 651 201 A1**
(43) Veröffentlichungstag der Anmeldung: **16.10.2013**
(21) Anmeldenummer: 12163557.7
(22) Anmeldetag: 10.04.2012
(51) Int. Cl.: H05K 5/02

(54) **Stromversorgungsgerät**

(71) Anmelder: Siemens Aktiengesellschaft, 80333 München (DE)
(72) Erfinder: Petricek, Martin, 2020 Hollabrunn (AT)

(57) **Zusammenfassung**

Die Erfindung betrifft ein Stromversorgungsgerät (1) mit einem Gehäuse (2) und einer Geräteaufhängung zur Anbringung an einer Aufnahmevorrichtung. Dabei umfasst die Geräteaufhängung einen Basisteil (3) und eine Befestigungsvorrichtung (4), wobei der Basisteil (3) mit dem Gehäuse (2) eine starre Einheit bildet und wobei die Befestigungsvorrichtung (4) starr mit der Aufnahmevorrichtung verbindbar ist und wobei des Weiteren der Basisteil (3) mit der Befestigungsvorrichtung (4) mittels wenigstens eines elastischen, schwingungsdämpfenden Elements (5) verbunden ist. Auf diese Weise sind die sensiblen Bauteile des Geräts (1), wie etwa die elektronischen Komponenten, schwingungstechnisch von der Befestigung entkoppelt.

## Beschreibung

Die Erfindung betrifft ein Stromversorgungsgerät mit einem Gehäuse und einer Geräteaufhängung zur Anbringung an einer Aufnahmevorrichtung.

Stromversorgungsgeräte werden in verschiedensten Umgebungen betrieben. Vor allem im industriellen Einsatz sind Stromversorgungen besonderen Beanspruchen ausgesetzt. Auftretende Stöße und Vibrationen können dazu führen, dass sich elektrische Kontakte lösen oder dass es zu einer Materialermüdung einzelner Gerätebauteile kommt.

Um derartigen Beschädigungen vorzubeugen geben Hersteller an, welchen Stößen und Schwingungsbelastungen ein Stromversorgungsgerät standhält. Zur Prüfung werden Schwingungstests und Schocktests durchgeführt, vorzugsweise entsprechend einer Norm wie der IEC 60068-2-6:2007. Diese Norm beschreibt ein Prüfungsverfahren für Geräte, die während eines Transports oder im Betrieb Bedingungen ausgesetzt sein können, welche Schwingungen mit einem gleichförmigen Muster zur Folge haben. Ein zu prüfendes Gerät wird für eine vorgegebene Prüfdauer einer sinusförmigen Schwingung mit einem gegebenen Frequenzbereich oder einzelnen Frequenzen unterworfen.

Nach dem Stand der Technik wird bei der Entwicklung und beim Zusammenbau von Stromversorgungsgeräten auf eine stabile Verbindung zwischen den einzelnen Bauteilen geachtet. Beispielsweise erfolgt eine zusätzliche mechanische Befestigung einzelner Bauteile, um Schwingungsbelastungen standzuhalten. Derartige Maßnahmen erhöhen jedoch den Konstruktionsaufwand und den Materialeinsatz, was zu einer Verteuerung und Gewichtszunahme führt.

Der Erfindung liegt die Aufgabe zugrunde, für ein Stromversorgungsgerät der eingangs genannten Art eine Verbesserung gegenüber dem Stand der Technik anzugeben.

Erfindungsgemäß wird diese Aufgabe gelöst durch die Merkmale des Anspruchs 1. Verbesserungen sind in abhängigen Ansprüchen angeführt.

Dabei umfasst die Geräteaufhängung ein Basisteil und eine Befestigungsvorrichtung, wobei der Basisteil mit dem Gehäuse eine starre Einheit bildet und wobei die Befestigungsvorrichtung starr mit der Aufnahmevorrichtung verbindbar ist und wobei des Weiteren der Basisteil mit der Befestigungsvorrichtung mittels wenigstens eines elastischen, schwingungsdämpfenden Elements verbunden ist. Auf diese Weise sind die sensiblen Bauteile des Geräts, wie etwa die elektronischen Komponenten, schwingungstechnisch von der Befestigung entkoppelt. Die auf die Befestigung des Stromversorgungsgeräts wirkenden Stoß- und Schwingungskräfte werden von dem wenigstens einem elastischen, schwingungsdämfenden Element aufgenommen. Bezogen auf ein ruhendes Bezugssystem behält der Basisteil mit dem Gehäuse im Wesentlichen seine Position und vollführt eine Relativbewegung zur Aufnahmevorrichtung entgegen den wirkenden Stoß- und Schwingbewegungen. Auf die Komponenten innerhalb des Gehäuses wirken somit nur stark abgedämpfte Kräfte, weshalb besondere Konstruktionsmaßnahmen entfallen können. Gegenüber herkömmlichen Stromversorgungsgeräten ist eine merkliche Gewichtseinsparung gegeben.

Eine weitere günstige Maßnahme zur Gewichtsreduktion sieht vor, dass der Basisteil als Gehäuserückwand ausgebildet ist.

In einer vorteilhaften Ausführung umfasst die Befestigungsvorrichtung zwei Befestigungseinheiten, wobei jeweils eine Befestigungseinheit mittels wenigstens eines elastischen, schwingungsdämpfenden Elements an gegenüberliegenden Seiten des Basisteils angeordnet ist. Jede Befestigungseinheit bildet eine Auflage zur Anbringung an einer Aufnahmevorrichtung. Die gegenüberliegende Anordnung bewirkt, dass auf das Gerät wirkende Drehmomente durch geringfügige Verformungen der elastischen, schwingungsdämpfenden Elemente aufgenommen werden.

Des Weiteren ist es vorteilhaft, wenn das Gehäuse im Wesentlichen quaderförmig ausgebildet ist und wenn jede Befestigungseinheit mit dem Basisteil mittels wenigstens zweier elastischer, schwingungsdämpfender Elemente verbunden ist, welche jeweils an Eckpositionen des quaderförmigen Gehäuses angeordnet sind. Auch diese besondere Anordnung trägt dazu bei, dass Drehmomente und Scherkräfte von den elastischen, schwingungsdämpfenden Elementen aufgenommen werden.

Zur einfachen Montage der Befestigungseinheiten auf einer Aufnahmevorrichtung ist vorteilhafterweise vorgesehen, dass jede Befestigungseinheit nach einer Seite hin offene Längsschlitze zur Aufnahme von Befestigungsmittel aufweist. Befestigungsschrauben können dann vor der Montage bereits teilweise in eine Aufnahmevorrichtung eingeschraubt sein. Die Befestigungseinheiten werden in weiterer Folge von der offenen Seite der Längsschlitze her unter die Schraubenköpfe der Befestigungsschrauben geschoben. Das vereinfacht eine rasche Positionierung des Stromversorgungsgeräts auf der Aufnahmevorrichtung.

Für eine Montage des Stromversorgungsgerätes auf einer ebenen Aufnahmevorrichtungen ist es von Vorteil, wenn die Befestigungseinheiten entlang einer gemeinsamen Montageebene ausgerichtet sind und wenn der Basisteil von dieser Montageebene beabstandet ist.

Eine günstige Ausprägung der Erfindung sieht vor, dass der Basisteil, die Befestigungsvorrichtung und das elastische, schwingungsdämpfende Element bzw. die elastischen schwingungsdämpfenden Elemente als einstückige Geräteaufhängung ausgebildet sind. Das vereinfacht die Fertigung der Geräteaufhängung und den Zusammenbau des Geräts.

Dabei ist es weiters günstig, wenn die einstückige Geräteaufhängung als ein Blechbauteil ausgebildet ist. An den Übergängen von Basisteil und Befestigungsvorrichtung weist der Blechbauteil durch geeignete Formgebung die erforderlichen elastischen und schwingungsdämpfenden Eigenschaften auf.

Eine einfache Formgebung sieht vor, dass das jeweilige elastische, schwingungsdämpfende Element als mäanderförmig gebogener Blechstreifen ausgebildet ist. Von der Seite aus gesehen ist der Blechstreifen beispielsweise Omega-förmig gebogen, um einen ausreichend langen Blechstreifenabschnitt zu schaffen. Unter anderem bestimmt das Verhältnis der Blechstreifenlänge zum Querschnitt des Blechstreifens die Schwingungseigenschaften des Gesamtsystems.

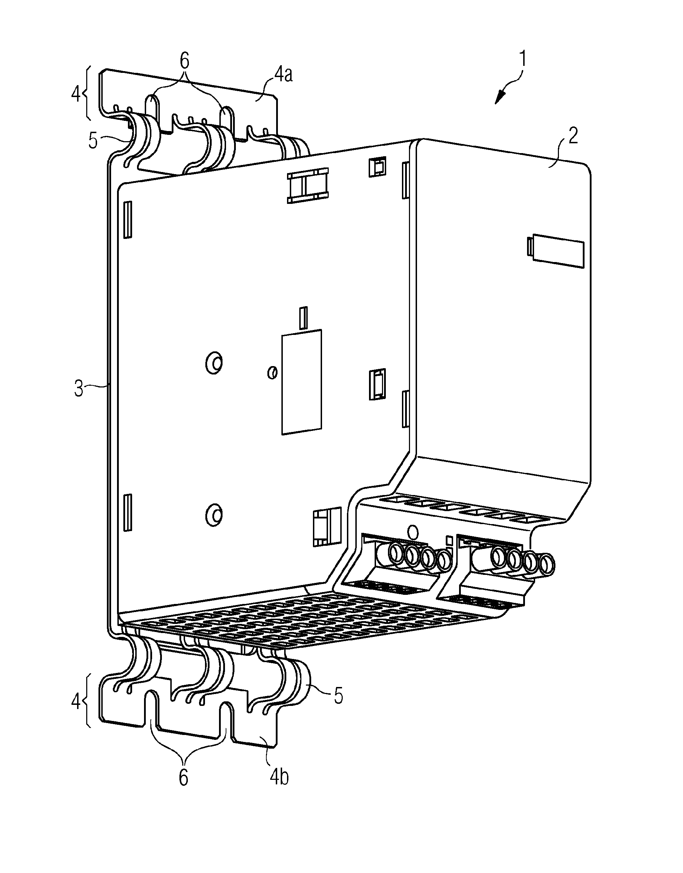

Die Erfindung wird nachfolgend in beispielhafter Weise unter Bezugnahme auf die beigefügte Figur erläutert. Dargestellt ist ein Stromversorgungsgerät 1 mit einem im Wesentlichen quaderförmigen Gehäuse 2. Die Rückseite des Gehäuses 2 ist als Basisteil 3 ausgebildet. Gezeichnet ist das Stromversorgungsgerät 1 in aufrechter Lage. Als nicht dargestellte Aufnahmevorrichtung dient beispielsweise eine Schaltschrankwand. Zur Beschreibung der einzelnen Komponenten wird in nicht einschränkender Weise auf diese aufrechte Lage Bezug genommen. Im vorliegenden Fall besteht die Befestigungsvorrichtung 4 aus zwei Befestigungseinheiten 4a, 4b. An der oberen Seite und an der unteren Seite des Basisteils 3 schließt über elastische, schwingungsdämpfende Elemente 5 jeweils eine Befestigungseinheit 4a, 4b an.

Dabei ist an den Eckpositionen des quaderförmigen Gehäuses jeweils ein elastisches, schwingungsdämpfendes Element 5 angeordnet. Zudem ist jede Befestigungseinheit 4a, 4b mittels eines mittig angeordneten elastischen, schwingungsdämpfenden Elements 5 mit dem Basisteil 3 verbunden. Jede Befestigungseinheit 4a, 4b ist also insgesamt über drei elastische, schwingungsdämpfende Elemente 5 an den Basisteil 3 angeschlossen.

Die elastischen, schwingungsdämpfenden Elemente 5 sind im vorliegenden Beispiel mit dem Basisteil 3 und den Befestigungseinheiten 4a, 4b einstückig als Blechteil ausgebildet. Jedes elastische, schwingungsdämpfende Element 5 besteht aus zwei nebeneinander liegenden, schmalen Blechstreifen, die von der Seite betrachtet Omega-förmig gebogen sind. Die Länge der Blechstreifen beträgt dabei ein Vielfaches der Blechstreifendicke und auch der Blechstreifenbreite. Durch diese Formgebung ist jeder Blechstreifen ausreichend elastisch um eine Relativbewegung zwischen der Befestigungsvorrichtung 4 und dem Basisteil 3 zuzulassen.

Sobald eine Stoß- oder Schwingungsanregung die Befestigungsvorrichtung 4 in Bewegung versetzt, bewirkt die Trägheitsmasse der mit dem Basisteil 3 verbundenen Gerätekomponenten eine relative Gegenbewegung, die durch die elastische Aufhängung ermöglicht wird. In einem absoluten Bezugssystem behält somit der Basisteil 3 mit den verbunden Gerätekomponenten seine Position weitgehend bei.

Die Eigenschaften der elastischen, schwingungsdämpfenden Elemente 5 sind dabei auf die Masse des Basisteils 3 und den mit diesem verbundenen Gerätekomponenten abgestimmt. Es liegt ein schwingungsfähiges System mit einer Eigenfrequenz vor.

Im dargestellten Beispiel wird durch geeignete Dimensionierung der Blechstreifen die Eigenfrequenz so eingestellt, dass sie ausreichend weit von möglichen Erregerfrequenzen entfernt ist. Dabei sind die Materialeigenschaften des Blechteils zu berücksichtigen. Auf diese Weise werden Resonanzschwingungen des Stromversorgungsgerätes 1 vermieden. Die von einer Aufnahmevorrichtung auf die Befestigungsvorrichtung 4 wirkenden Kräfte führen dazu, dass in den Blechstreifen Verformungsenergie freigesetzt wird, mit einem dämpfenden Effekt auf das schwingungsfähige System.

Zur Überprüfung der richtigen Dimensionierung der elastischen, schwingungsdämpfenden Elemente 5 wird eine Schwingungs- und Schockprüfung sinnvollerweise über mehrere Stunden hinweg (z.B. 4,5 Std.) für alle drei Bewegungsachsen eines kartesischen Bezugssystems durchgeführt. Während eines Tests schadlos durchlaufende Erregerfrequenzen liegen beispielsweise zuwischen 5 und 150 Hertz, um die Anforderungen gängiger Industrieanwendungen von Stromversorgungsgeräten zu erfüllen.

Die Eigenfrequenz des schwingungsfähigen Systems liegt somit außerhalb dieses Frequenzbereichs, zum Beispiel zwischen 160 und 200 Hertz.

Um den Zweck für die vorliegende Erfindung zu erfüllen, können unterschiedlichste elastische, schwingungsdämpfende Elemente 5 zum Einsatz kommen. Die im Beispiel gezeigte Ausführung stellt lediglich eine günstige, einfach herzustellende Ausprägung dar.

Alternativ dazu sind Elemente 5 anordenbar, die ihre Wirkung weniger durch Formgebung als durch elastische und dämpfende Materialeigenschaften erzielen. Das sind beispielsweise Elemente 5 aus Gummi oder ähnlichen Materialien.

Solche Elemente 5 können ringförmig ausgebildet und zwischen Haken des Basisteils 1 und der Befestigungsvorrichtung 4 gespannt sein.

Die Befestigungselemente 4a, 4b sind im vorliegenden Beispiel als flache Blechabschnitte ausgebildet und an einer gemeinsamen Montageebene ausgerichtet. Der Basisteil 3 ist von dieser Montageebene beabstandet, sodass bei einer ebenen durchgängigen Aufnahmevorrichtung der Basisteil 3 frei gestellt ist und nicht auf der Aufnahmevorrichtung aufliegt.

Montiert werden die Befestigungselemente 4a, 4b zum Beispiel mittels Schrauben. Dafür sind die Befestigungselemente 4a, 4b mit Längsschlitzen 6 versehen, die nach unten hin offen sind. Diese Längsschlitze 6 greifen bei der Montage hinter Schraubenköpfe von in der Aufnahmevorrichtung eingeschraubten Befestigungsschrauben.

Auch hierbei handelt es sich um eine einfache vorteilhafte Ausprägung einer Befestigungseinrichtung. Alternativen stellen Klippsystem oder sonstige lösbare Befestigungsarten dar.

## Patentansprüche

1. Stromversorgungsgerät (1) mit einem Gehäuse (2) und einer Geräteaufhängung zur Anbringung an einer Aufnahmevorrichtung, **dadurch gekennzeichnet, dass** die Geräteaufhängung einen Basisteil (3) und eine Befestigungsvorrichtung (4) umfasst, dass der Basisteil (3) mit dem Gehäuse (2) eine starre Einheit bildet und dass die Befestigungsvorrichtung (4) starr mit der Aufnahmevorrichtung verbindbar ist und dass des Weiteren der Basisteil (3) mit der Befestigungsvorrichtung (4) mittels wenigstens eines elastischen, schwingungsdämpfenden Elements (5) verbunden ist.

2. Stromversorgungsgerät nach Anspruch 1, **dadurch gekennzeichnet, dass** der Basisteil (1) als Gehäuserückwand ausgebildet ist.

3. Stromversorgungsgerät nach Anspruch 1 oder 2, **dadurch gekennzeichnet, dass** die Befestigungsvorrichtung (4) zwei Befestigungseinheiten (4a, 4b) umfasst und dass jeweils eine Befestigungseinheit (4a bzw. 4b) mittels wenigstens eines elastischen, schwingungsdämpfenden Elements (5) an gegenüberliegenden Seiten des Basisteils (3) angeordnet ist.

4. Stromversorgungsgerät nach Anspruch 3, **dadurch gekennzeichnet, dass** das Gehäuse (2) im Wesentlichen quaderförmig ausgebildet ist und dass jede Befestigungseinheit (4a, 4b) mit dem Basisteil (3) mittels wenigstens zweier elastischer, schwingungsdämpfender Elemente (5) verbunden ist, welche jeweils an Eckpositionen des quaderförmigen Gehäuses (2) angeordnet sind.

5. Stromversorgungsgerät nach Anspruch 3 oder 4, **dadurch gekennzeichnet, dass** jede Befestigungseinheit (4a, 4b) nach einer Seite hin offene Längsschlitze (6) zur Aufnahme von Befestigungsmittel aufweist.

6. Stromversorgungsgerät nach einem der Ansprüche 3 bis 5, **dadurch gekennzeichnet, dass** die Befestigungseinheiten (4a, 4b) entlang einer gemeinsamen Montageebene ausgerichtet sind und dass der Basisteil (3) von dieser Montageebene beabstandet ist.

7. Stromversorgungsgerät nach einem der Ansprüche 1 bis 6, **dadurch gekennzeichnet, dass** der Basisteil (3), die Befestigungsvorrichtung (4) und das elastische, schwingungsdämpfende Element (5) bzw. die elastischen schwingungsdämpfenden Elemente (5) als einstückige Geräteaufhängung ausgebildet sind.

8. Stromversorgungsgerät nach Anspruch 7, **dadurch gekennzeichnet, dass** die einstückige Geräteaufhängung als ein Blechbauteil ausgebildet ist.

9. Stromversorgungsgerät nach einem der Ansprüche 1 bis 8, **dadurch gekennzeichnet, dass** das jeweilige elastische, schwingungsdämpfende Element (5) als mäanderförmig gebogener Blechstreifen ausgebildet ist.

10. Stromversorgungsgerät nach einem der Ansprüche 1 bis 9, **dadurch gekennzeichnet, dass** das jeweilige elastische, schwingungsdämpfende Element (5) als Omega-förmiger Blechstreifen ausgebildet ist.
